# EUROPÄISCHE PATENTSCHRIFT

(11) **EP 0 811 703 B1**
(45) Veröffentlichungstag und Bekanntmachung des Hinweises auf die Patenterteilung: **25.09.2002**
(21) Anmeldenummer: 97108818.2
(22) Anmeldetag: 02.06.1997
(51) Int. Cl.: C23C 16/50, C23C 16/44, C23C 16/46

(54) **Vorrichtung zum Behandeln eines Substrats**
Apparatus for treatment of a substrate
Dispositif de traitement d'un substrate

(30) Priorität: 04.06.1996 DE 19622402
(43) Veröffentlichungstag der Anmeldung: 10.12.1997
(73) Patentinhaber: Infineon Technologies AG, 81669 München (DE)
(72) Erfinder: Rupp, Roland, Dr., 91207 Lauf (DE); Völkl, Johannes, 91056 Erlangen (DE)
(74) Vertreter: Epping, Wilhelm, Dipl.-Ing.

(56) Entgegenhaltungen:
- DE-A- 4 330 266
- US-A- 5 284 519
- PARSONS J D: "INVERTED-VERTICAL OMVPE REACTOR: DESIGN AND CHARACTERIZATION" JOURNAL OF CRYSTAL GROWTH, Bd. 116, Nr. 3/04, 1. Februar 1992, Seiten 387-396, XP000265338

## Beschreibung

Die Erfindung bezieht sich auf eine Vorrichtung zum Behandeln eines Substrats.

Aus *EP-A-0 251 825* ist eine Vorrichtung zum Abscheiden von Epitaxieschichten auf Substraten durch chemische Gasphasenabscheidung (Chemical Vapour Deposition = CVD) bekannt. Diese bekannte Vorrichtung umfaßt mehrere vertikal, d.h. parallel zur Schwerkraft (Erdanziehungskraft, Gravitationskraft), angeordnete Suszeptoren, die jeweils mehrere Substrate aufnehmen und entlang ihrer Längsachse drehbar sind. Die Suszeptoren sind entlang einer Kreislinie um ein im Zentrum angeordnetes, ebenfalls vertikal verlaufendes Gaseinlaßrohr angeordnet. Durch Öffnungen in dem Gaseinlaßrohr strömen Prozeßgase zum Abscheiden der Epitaxieschichten auf den Substraten in im wesentlichen horizontaler Richtung, d.h. senkrecht zur Schwerkraft, auf die Substrate zu.

Aus *US 3,408,982* ist eine weitere Vorrichtung zum Abscheiden von Epitaxieschichten auf Substraten durch CVD bekannt. Diese bekannte Vorrichtung umfaßt einen tellerförmigen Suszeptor, der horizontal, d.h. senkrecht zur Schwerkraft, angeordnet ist und mit einem vertikal, d.h. parallel zur Schwerkraft, angeordneten rotierenden Schaft verbunden ist. Auf dem Suszeptor sind in einer Ausführungsform die Substrate horizontal angeordnet. Durch den rotierenden Schaft werden die CVD-Prozeßgase von unten nach oben geführt und treten in einen Gasraum oberhalb des Suszeptortellers ein. In dem Gasraum strömen die Prozeßgase im wesentlichen radial bezogen auf den rotierenden Schaft nach außen und treffen auf die Substrate im wesentlichen senkrecht von oben, d.h. in Richtung der Schwerkraft, auf. Unterhalb der Substrate ist eine Induktionsheizspule angeordnet, die in Form einer flachen Spirale (Pancake-Spule) ausgebildet ist. In einer weiteren Ausführungsform ist der Suszeptorteller an seinen Rändern nach oben abgeschrägt und die Substrate sind auf dem schrägen Teil des Suszeptortellers nach innen geneigt angeordnet, um die Zentrifugalkraft auszugleichen. Die zugeordnete Induktionsspule ist ebenfalls schräg angeordnet. Diese aus *US 3,408,982* bekannte Vorrichtung ist insbesondere zum Herstellen von Siliciumepitaxieschichten vorgesehen, wobei Temperaturen zwischen 1190°C und 1450°C eingestellt werden für den CVD-Prozeß.

Ein Problem bei der aus *US 3,408,982* bekannten Vorrichtung sind die durch die Induktionsheizung induzierten elektromagnetischen Kräfte auf den Suszeptor und auch auf die Substrate. Diese elektromagnetischen Kräfte destabilisieren den mechanischen Aufbau, wodurch sich auch die Temperaturverteilung an den Substraten ändern kann.

Der Erfindung liegt nun die Aufgabe zugrunde, eine Vorrichtung zum Behandeln eines Substrats anzugeben, bei der das Substrat mit einer Induktionsheizeinrichtung und einem zugehörigen Suszeptor beheizt wird und bei der die durch die Induktionsheizung wirkenden elektromagnetischen Kräfte die Lage des Suszeptors während der Behandlung des Substrats nicht wesentlich beeinflussen.

Diese Aufgabe wird gemäß der Erfindung gelöst mit den Merkmalen des Anspruchs 1.

Die Vorrichtung zum Behandeln wenigstens eines Substrats umfaßt
a) wenigstens einen mit dem wenigstens einen Substrat thermisch gekoppelten Suszeptor und
b) eine Induktionsheizeinrichtung zum induktiven Erhitzen des wenigstens einen Suszeptors,
wobei
c) die Induktionsheizeinrichtung und der wenigstens eine Suszeptor so zueinander angeordnet sind, daß eine durch die Induktionsheizeinrichtung auf den wenigstens einen Suszeptor einwirkende elektromagnetische Kraft wenigstens annähernd gleichgerichtet zur Gravitationskraft ist.

Im Gegensatz zu bekannten Anordnungen, bei denen die auf den Suszeptor durch die Induktionsheizung ausgeübte elektromagnetische Kraft antiparallel zur Schwerkraft ist, wird durch die Maßnahmen gemäß der Erfindung ein stabiler mechanischer und thermischer Aufbau erreicht.

Vorteilhafte Ausgestaltungen und Weiterbildungen der Vorrichtung ergeben sich aus den vom Anspruch 1 abhängigen Ansprüchen.

Die Induktionsheizeinrichtung umfaßt insbesondere wenigstens eine Induktionsspule, die vorzugsweise von einer Hochfrequenzspannungsquelle betrieben wird.

In einer ersten Ausführungsform ist das wenigstens eine Substrat zwischen dem wenigstens einen Suszeptor und der Induktionsspule angeordnet.

In einer anderen vorteilhaften Ausführungsform ist umgekehrt der wenigstens eine Suszeptor zwischen der Induktionsspule und dem wenigstens einen Substrat angeordnet. Der Suszeptor kann dann an seiner von der Induktionsspule abgewandten Seite mit wenigstens einer Einstecklasche für zum Befestigen des wenigstens einen Substrats versehen sein und insbesondere auch auf einem Trägerstab abgestützt sein.

Die Vorrichtung kann ferner wenigstens eine Trägereinrichtung zum Tragen des wenigstens einen Substrats und des wenigstens einen Suszeptors umfassen. Vorzugsweise weist die Trägereinrichtung eine Trägerschale mit jeweils einer Öffnung und einer die Öffnung umgebenden Auflagefläche für jedes Substrat auf, wobei der Suszeptor in die Trägerschale einlegbar ist. Die Trägerschale kann auf einem Trägerstab abgestützt sein.

In einer weiteren Ausführungsform weist die Vorrichtung Rotationsmittel zum Rotieren jedes Substrats um eine gemeinsame oder jeweils eine vorgegebene Drehachse auf. Insbesondere kann in den Ausführungsformen mit Trägerstab der Trägerstab um seine Längsachse gedreht werden. In der Ausführungsform einer Trägereinrichtung mit Trägerschale kann dabei die gesamte Trägerschale rotiert werden.

Vorzugsweise ist die Vorrichtung zum Abscheiden einer Schicht auf einer Oberfläche des wenigstens einen Substrats vorgesehen und umfaßt dazu Mittel zum Richten eines Prozeßgasstromes auf die Oberfläche des wenigstens einen Substrats zum chemischen Abscheiden der Schicht aus dem Prozeßgasstrom. Diese Mittel zum Richten des Prozeßgasstromes auf die Oberfläche des Substrats sind vorzugsweise so ausgebildet, daß die Strömungsrichtung des Gasstromes wenigstens im Bereich der Oberfläche des Substrats wenigstens annähernd antiparallel zur Gravitationskraft gerichtet ist.

Eine bevorzugte Anwendung findet die Vorrichtung beim Abscheiden einer Schicht aus einkristallinem Siliciumcarbid oder auch aus einkristallinem Galliumnitrid auf einem Substrat.

Zur weiteren Erläuterung der Erfindung wird auf die Zeichnungen Bezug genommen.
- FIG 1: zeigt eine Ausführungsform einer Vorrichtung zum Behandeln mehrerer Substrate mit einer Trägereinrichtung für diese Substrate in einem Querschnitt.
- FIG 2: stellt die Trägereinrichtung der FIG 1 in einer Draufsicht dar.
- FIG 3: veranschaulicht eine Ausführungsform einer Vorrichtung zum Beschichten eines Substrats von unten mit einer von oben rotierbaren Trägereinrichtung für das Substrat.

- FIG 4: stellt eine Vorrichtung zum Beschichten eines Substrats von unten mit einer von unten rotierbaren Trägereinrichtung für das Substrat dar.
- FIG 5: zeigt eine Vorrichtung zum Beschichten eines Substrats mit horizontaler Prozeßgasführung.
- FIG 6: ist eine Darstellung einer Trägereinrichtung mit Einstecklaschen für mehrere Substrate.
- FIG 7: veranschaulicht eine Vorrichtung zum Behandeln mehrerer Substrate mit einer Prozeßgaszuführung von unten.

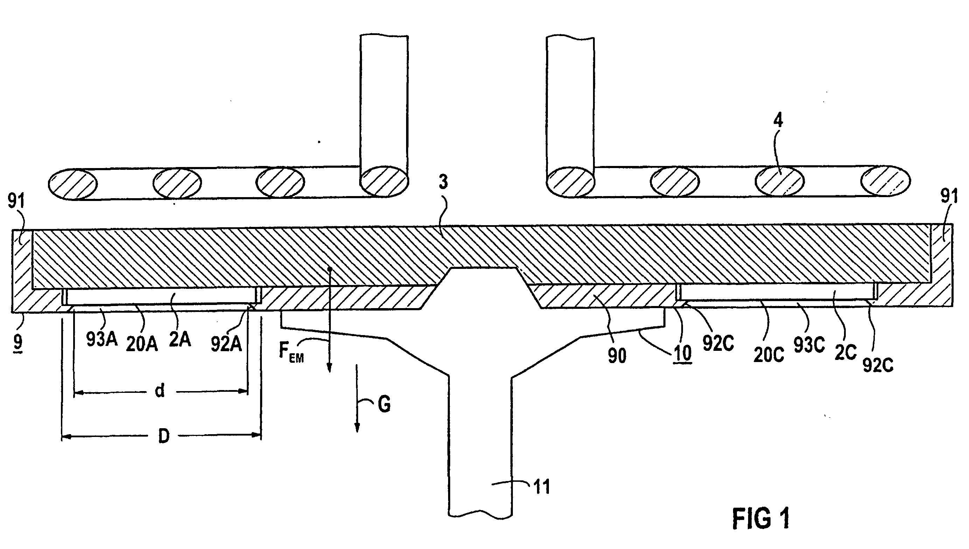

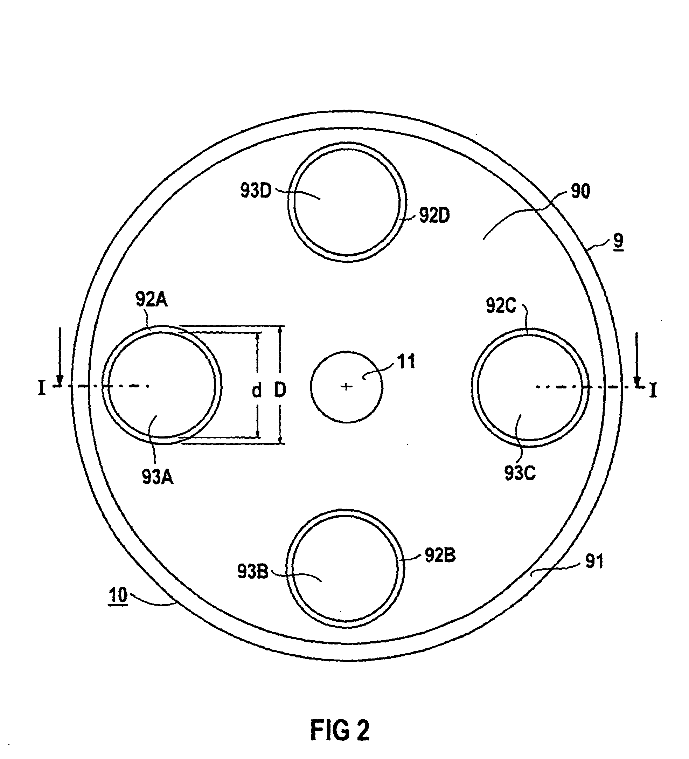

Die Vorrichtung zum Behandeln wenigstens eines Substrats gemäß FIG 1 umfaßt eine Trägereinrichtung 10 für das wenigstens eine Substrat, einen Suszeptor 3, eine Induktionsspule 4 und einen Trägerstab 11. In FIG 2 ist die Trägereinrichtung 10 in einer Draufsicht von oben ohne Suszeptor 3 und Induktionsspule 4 dargestellt. Im Querschnitt der FIG 1 sind zwei Substrate 2A und 2C dargestellt, in der Draufsicht der FIG 2 vier Substrate 2A, 2B, 2C und 2D. Die Trägereinrichtung 10 umfaßt eine Trägerschale 9 und einen Trägerstab 11, der zentrisch die Trägerschale 9 abstützt. Die Trägerschale 9 besteht aus einer Grundplatte 90 und einem seitlichen, nach oben ragenden Rand 91. In der Grundplatte 90 sind für jedes Substrat 2A bis 2D jeweils eine Öffnung 93A bis 93D vorgesehen. Um jede dieser Öffnungen 93A bis 93D ist eine Auflagefläche 92A bis 92D in der Grundplatte 90 gebildet, auf die jeweils eines der Substrate 2A bis 2D aufgelegt wird. Vorzugsweise sind die Auflageflächen 92A bis 92D in die Grundplatte zurückgesetzt, so daß ein zylindrisches Lager für das Substrat gebildet ist mit einem durch die Öffnung 93A bis 93D definierten inneren Durchmesser d und einem durch die radiale Ausdehnung der Auflagefläche 92A bis 92D definierten äußeren Durchmesser D. Der innere Durchmesser D ist kleiner gewählt als der Durchmesser der Substrate 2A bis 2D, während der äußere Durchmesser D größer gewählt ist als der Durchmesser der Substrate 2A bis 2D. Neben der dargestellten Kreisform können die Auflageflächen 92A bis 92D natürlich auch einer anderen Form der Substrate angepaßt werden, beispielsweise einer rechteckigen Form.

In der FIG 2 sind zwar nur vier Auflageflächen 92A bis 92D dargestellt. Im allgemeinen wird man jedoch mehr als vier Auflageflächen für entsprechend mehr Substrate vorsehen und diese Auflageflächen auch möglichst dicht nebeneinander anordnen.

Nach dem Einbringen der Substrate 2A bis 2D auf die entsprechenden Auflageflächen 92A bis 92D wird in die Trägerschale 9 der Suszeptor 3 eingebracht, der vorzugsweise dem Innendurchmesser der Trägerschale 9 angepaßt ist und insbesondere die Form einer Kreisscheibe haben kann. Der Suszeptor 3 ist thermisch mit den Substraten 2A bis 2D gekoppelt. Die thermische Kopplung kann über Wärmeleitung oder auch über Wärmestrahlung oder beides geschehen. Vorzugsweise steht der Suszeptor 3 dazu in direktem Kontakt mit den Substraten 2A bis 2D. Die Trägerschale 9 ist vorzugsweise auf den Trägerstab 11 aufsteckbar und damit lösbar verbunden. Dies ermöglicht einen einfachen Wechsel der Substrate nach der Behandlung. Die Induktionsspule 4 ist vorzugsweise eine Flachspule in der Art einer Pancake-Spule und ist oberhalb des Suszeptors 3 wenigstens annähernd parallel zu der Trägerschale 9 und zu den Substraten 2A bis 2D sowie dem Suszeptor 3 angeordnet.

Der Suszeptor 3 besteht im allgemeinen aus einem elektrisch leitfähigen Material. Bei Anlegen einer vorzugsweise hochfrequenten Wechselspannung an die Induktionsspule 4 werden in dem Suszeptor 3 Wirbelströme induziert, die in Joulesche Wärme umgewandelt werden. Durch die thermische Kopplung wird diese Wärme vom Suszeptor 3 auf die Substrate 2A bis 2D übertragen. Aufgrund der Induktion (Lenzsche Regel) wirkt auf den Suszeptor 3 eine elektromagnetische Kraft (Kraftvektor) **F**_{**EM**}**.** Die besondere Anordnung von Suszeptor 3 und Induktionsspule 4 relativ zueinander hat zur Folge, daß diese elektromagnetische Kraft **F**_{**EM**} gleichgerichtet zur Gewichtskraft des Suszeptors 3 und damit zur Gravitationskraft (Kraftvektor) **G** ist. Gleichgerichtet bedeutet, daß die zugehörigen Kraftpfeile (Vektoren) in die gleiche Richtung zeigen. Die Gesamtkraft auf den Suszeptor 3 ergibt sich als vektorielle Summe **F**_{**EM**} + **G** der elektromagnetischen Kraft **F**_{**EM**} und der Gravitationskraft **G.** Diese Gesamtkraft **F**_{**EM**} + **G** zeigt immer in Richtung der Gravitationskraft **G** unabhängig von dem Stromfluß in der Induktionsspule 4 und ist betragsmäßig immer wenigstens so groß wie der Betrag der auf den Suszeptor 3 wirkenden Schwerkraft **G**. Damit wird während der Behandlung und des Betriebs der Induktionsspule 4 der Suszeptor 3 immer in seiner Lage gehalten und hebt nicht von den Substraten 2A bis 2D ab. Somit sind auch eine gleichmäßige Wärmeversorgung der Substrate 2A bis 2D und gleichmäßige Temperaturen an deren Substratoberflächen 20A bis 20D gewährleistet. Da überdies die Substrate 2A bis 2D durch ihre eigene Gewichtskraft und die Gewichtskraft des Suszeptors 3 gegen die zugehörigen Auflageflächen 92A bis 92D gedrückt werden, können praktisch keine Verunreinigungen vom Suszeptor 3 zu den behandelten Substratoberflächen 20A bis 20D gelangen. Diese Verunreinigungen durch den Suszeptor 3 sind besonders kritisch, da der Suszeptor 3 im allgemeinen auf der höchsten Temperatur im Gesamtsystem liegt. Somit wird insbesondere beim Aufwachsen einer Epitaxieschicht auf jedem Substrat 2A bis 2D die Qualität der aufwachsenden Epitaxieschicht verbessert.

In der in den FIG 1 und 2 dargestellten Ausführungsform werden freie Oberflächen 20A bis 20D der Substrats 2A bis 2D von unten behandelt. Diese Oberflächen 20A und 20C sind vorzugsweise senkrecht zur Schwerkraft **G** gerichtet. Dadurch werden die Substrate 2A bis 2D durch ihre eigene Gewichtskraft gegen die Auflageflächen 92A bis 92D gedrückt, und man erreicht eine stabile thermische Kopplung zum Suszeptor 3.

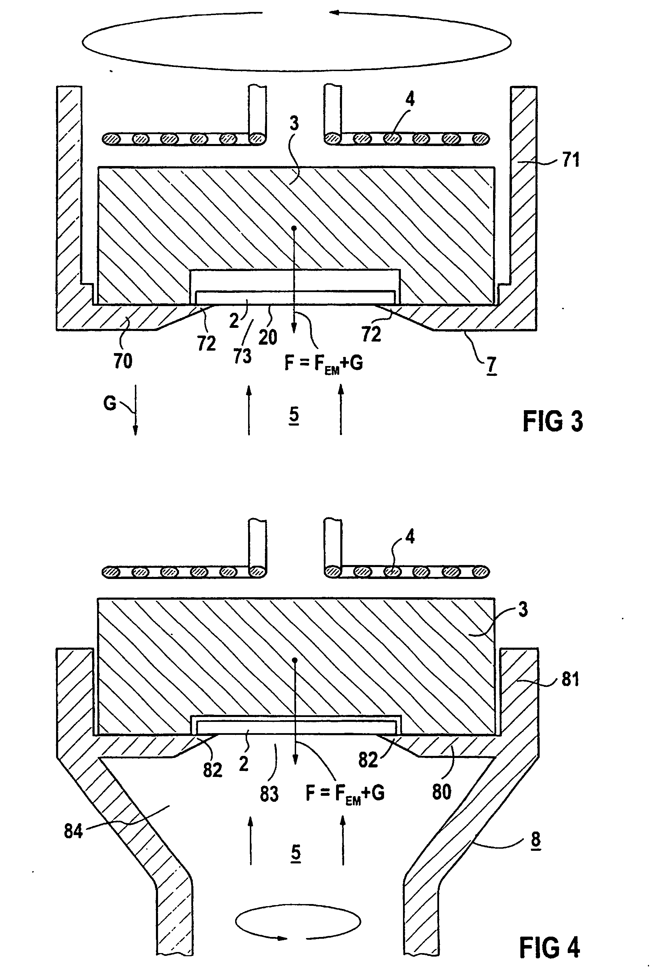

In FIG 3 ist eine Ausführungsform einer Vorrichtung zum Behandeln eines Substrats 2 gezeigt. Das Substrat 2 liegt mit seinem Rand auf einer Auflagefläche 72 einer Trägereinrichtung 7. Die Auflagefläche 72 bildet den Rand einer Öffnung 73 in einer Grundplatte 70 der Trägereinrichtung 7. Durch die Öffnung 73 in der Grundplatte 70 ist die nach unten gewandte Oberfläche 20 des Substrats 2 zugänglich. Aus einem mit 5 bezeichneten Prozeßgasstrom, der von unten auf die Oberfläche 20 des Substrats 2 strömt, kann deshalb das Substrat 2 an seiner Oberfläche 20 beispielsweise geätzt werden oder vorzugsweise mit einer nicht dargestellten Schicht versehen werden, insbesondere durch ein CVD-Verfahren. Aus strömungsdynamischen Gründen ist die Auflagefläche 72 vorzugsweise schräg gestaltet, so daß ihr Durchmesser zum Substrat 2 hin kontinuierlich abnimmt. Die Auflagefläche 72 und das aufliegende Substrat 2 sind im wesentlichen senkrecht zur Schwerkraft **G** gerichtet. Neben der Grundplatte 70 weist die Trägereinrichtung 7 ein Seitenteil 71 auf, das beispielsweise hohlzylindrisch ausgestaltet sein kann und sich nach oben, also entgegengesetzt zur Schwerkraft **G**, fortsetzt. Vorzugsweise ist die Trägereinrichtung 7 von oben her rotierbar um eine vorzugsweise parallel zur Schwerkraft G verlaufende Drehachse. In der Trägereinrichtung 7 ist auf der Grundplatte 70 ein Suszeptor 3 angeordnet, der von dem Seitenteil 71 begrenzt ist und thermisch mit dem Substrat 2 gekoppelt ist. Oberhalb des Suszeptors 3 ist wieder eine Induktionsspule 4 angeordnet. Die auf den Suszeptor 3 resultierende Gesamtkraft **F = F**_{**EM**} **+ G** ist mit einem Pfeil dargestellt, der die Richtung dieser wirkenden Kraft darstellt, und ist immer gleichgerichtet zur Gravitationskraft **G**, so daß der Suszeptor 3 fest auf der Trägereinrichtung 7 verharrt und eine konstante thermische Kopplung zum Substrat 2 sowie ein stabiler mechanischer Aufbau gewährleistet sind.

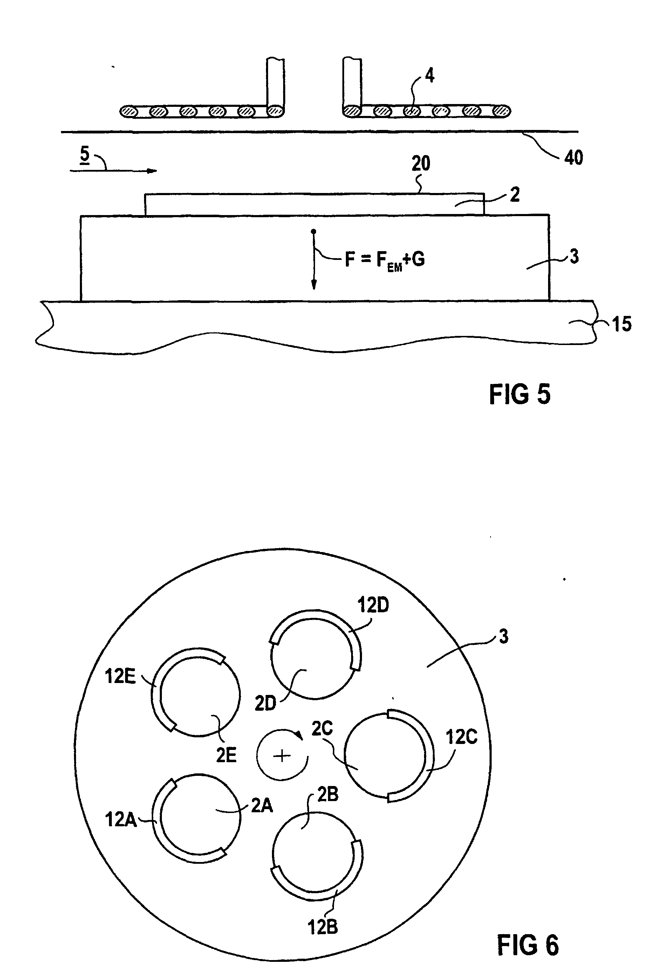

FIG 4 zeigt einen ähnlichen Aufbau der Vorrichtung wie in FIG 3, jedoch mit einer abgewandelten Trägereinrichtung, die mit 8 bezeichnet ist. Die Trägereinrichtung 8 weist ebenso wie die Trägereinrichtung 7 in FIG 3 eine Grundplatte 80 auf mit einer Öffnung 83 und einer Auflagefläche 82, auf der das Substrat 2 aufliegt. Jedoch setzt sich die Trägereinrichtung 8 nicht wie in FIG 3 nach oben, sondern nach unten in Richtung der Schwerkraft **G** fort und ist auch, bezogen auf das Substrat 2, unten befestigt. Ferner ist die Trägereinrichtung 8 innen hohl und wird in dem von ihr umschlossenen Hohlraum 84 von den Prozeßgasen 5 durchströmt. Zum Abführen der Prozeßgase 5 nach ihrem Auftreffen auf das Substrat 2 sind vorzugsweise nicht dargestellte Öffnungen im oberen Bereich der Trägereinrichtung 8 vorgesehen. Vorzugsweise verjüngt sich der Hohlraum 84 innerhalb der Trägereinrichtung 8 nach unten und nimmt dort die Gestalt eines Schaftes an. Vorzugsweise ist dieser schaftförmige Teil der Trägereinrichtung 8 mit Rotationsmitteln, beispielsweise einem Motor, verbunden, um das Substrat 2 während der Behandlung um eine vorzugsweise parallel zur Gravitationskraft **G** gerichtete Drehachse zu rotieren. Auf der Grundplatte 80 der Trägereinrichtung 8 ist wieder, umfaßt von einem Seitenteil 81, ein Suszeptor 3 angeordnet, der von einer über dem Suszeptor 3 angeordneten Induktionsspule 4 induktiv erwärmt wird zum Beheizen des Substrats 2. Der Suszeptor 3 wird möglichst paßgenau auf das Substrat 2 aufgesetzt.

FIG 5 zeigt einen einfachen Aufbau einer Vorrichtung zum Behandeln eines Substrats 2. Das Substrat 2 ist nun mit seiner gesamten Unterseite flächig auf dem Suszeptor 3 angeordnet, der vorzugsweise auf einer Unterlage 15 angeordnet ist. Eine Induktionsspule 4 ist oberhalb des Substrats 2 angeordnet, so daß das Substrat 2 zwischen Induktionsspule 4 und Suszeptor 3 angeordnet ist. Der in FIG 5 dargestellten Ausführungsform strömen Prozeßgase 5 in horizontaler, d.h. parallel zur Oberfläche 20 des Substrats 2 verlaufender Richtung über die Oberfläche 20. Um zu vermeiden, daß die Prozeßgase 5 mit der Induktionsspule 4 in Kontakt treten, kann eine symbolisch dargestellte Trennwand 40 vorgesehen sein. Da auch in der in FIG 5 dargestellten Ausführungsform die elektromagnetische Kraft **F**_{**EM**} und die auf den Suszeptor 3 wirkende Gesamtkraft **F** = **F**_{**EM**} + **G,** die auf den Suszeptor 3 wirkt, gleichgerichtet zur auf den Suszeptor 3 wirkenden Gravitationskraft **G** sind, ist der Aufbau stabil. Insbesondere kann der Suszeptor 3 auch bei sich ändernder elektrischer Energie in der Induktionsspule 4 nicht von der Unterlage 15 abheben.

Die FIG 6 zeigt eine Ausführungsform, bei der der Suszeptor selbst als Trägereinrichtung für das wengistens eine Substrat vorgesehen ist. In FIG 6 ist ein Suszeptor 3 von unten dargestellt. Der Suszeptor 3 weist an seiner Unterseite für jedes Substrat 2A bis 2E eine Einstecklasche (Aufnahmetasche) 12A bis 12E auf, die in ihrer Form der Form des zugeordneten Substrats 2A bis 2E angepaßt ist und im Beispiel der Figur halbkreisförmig ist. Die Substrate 2A bis 2E können in die zugehörigen Einstecklaschen 12A bis 12E seitlich eingesteckt werden und werden von diesen Einstecklaschen 12A bis 12E festgehalten. Vorzugsweise wird der Suszeptor 3 um eine Drehachse zentrisch gedreht. Die Einstecklaschen 12A bis 12E sind nun radial so angeordnet, daß die Substrate 2A bis 2E in die zugehörige Einstecklasche 12A bis 12E durch die Zentrifugalkraft bei der Drehung des Suszeptors 3 gedrückt werden und somit zusätzlich mechanisch stabilisiert werden. Die Behandlung der Substrate 2A bis 2E geschieht in dieser Ausführungsform von unten, d.h. in Blickrichtung auf die Unterseite des Suszeptors 3. Die nicht dargestellte Induktionsspule ist auf der Oberseite des Suszeptors 3 angeordnet.

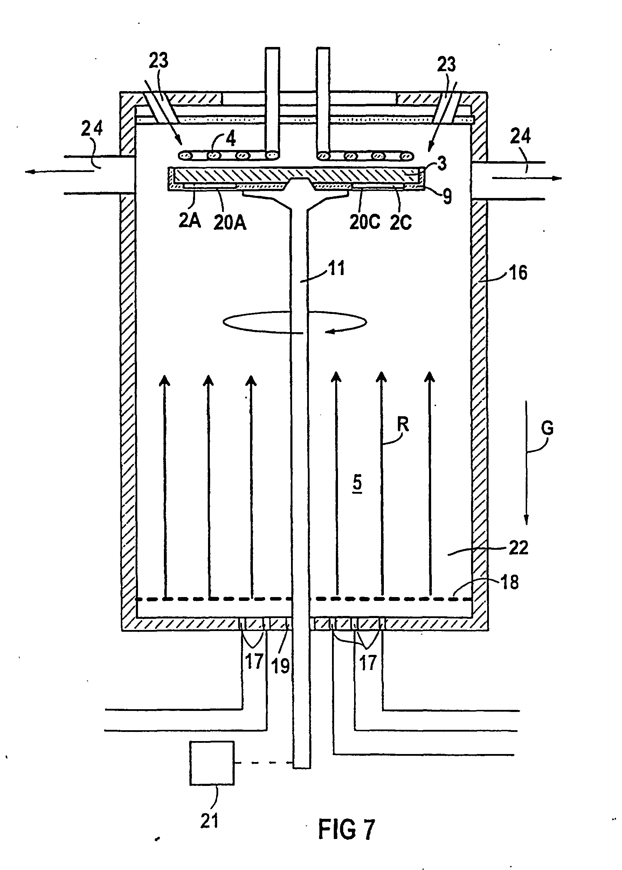

FIG 7 zeigt eine Vorrichtung zum Abscheiden von Schichten auf mehreren Substraten durch CVD. Die Vorrichtung enthält eine Trägereinrichtung mit einer Trägerschale 9 und einem Trägerstab 11 sowie einen Suszeptor 3, die analog wie in FIG 1 aufgebaut sind und denen wie in FIG 1 eine Induktionsspule **4** zugeordnet ist. Dieser Aufbau ist nun in einem Reaktor 16 angeordnet, an dessen Unterseite, d.h. in Richtung der Schwerkraft **G** gesehen, unterhalb der Substrate 2A und 2C Mittel zum Richten eines Prozeßgasstromes 5 auf die Substratoberflächen 20A und 20C vorgesehen sind. Diese Mittel zum Richten des Prozeßgasstromes 5 umfassen Gaseinlaßöffnungen 17 in dem Reaktor 16, durch die die verschiedenen Prozeßgase in den Reaktor 16 geleitet werden und einen Diffusor 18, mit dessen Hilfe ein homogener Prozeßgasstrom 5 erzeugt wird. Der Diffusor 18 kann mit einem Drahtgeflecht einer vorgesehenen Maschenweite gebildet sein. Der Prozeßgasstrom 5 strömt von einem auf niedrigeren Temperaturen als die Substrate 2A bis 2E liegenden Raumbereich 22 auf die Substratoberflächen 20A bis 20E und wird danach seitlich abgelenkt und über mit Pumpen verbundenen Auslässe 24 aus dem Reaktor 16 geführt. Vorzugsweise sind zum Schutz der Induktionsspule 4 vor dem Prozeßgasstrom 5 Gaseinlässe 23 vorgesehen, über die die Induktionsspule 4 und vorzugsweise auch der Suszeptor 3 mit einem Inertgas, vorzugsweise Argon, gespült werden. Der Trägerstab 11, auf den die Trägerschale 9 aufgesetzt ist, geht durch den gesamten Reaktor 16 nach unten und wird durch eine gasdichte Öffnung, insbesondere eine Drehdichtung, außerhalb des Reaktors 16 geführt. Dort sind Rotationsmittel 21 vorgesehen, die mit dem Trägerstab 11 in Wirkverbindung stehen und den Trägerstab 11 entlang seiner Längsachse rotieren können. Die Rotationsgeschwindigkeit wird dabei entsprechend den Anforderungen variabel eingestellt. Als Rotationsmittel 21 kann beispielsweise ein Elektromotor mit einer entsprechenden Übersetzung vorgesehen sein.

Die entgegengesetzt zur Schwerkraft **G** gerichtete Strömungsrichtung des Prozeßgasstromes 5 ist mit R bezeichnet und zeigt in Richtung der dargestellten Pfeile. Durch die antiparallele Ausrichtung von Strömungsrichtung R und Gravitationskraft **G** wird eine stabile thermische Schichtung im Gasraum innerhalb des Reaktors 16 erreicht, die praktisch keine Verwirbelung zeigt. Alle Parameter wie Rotationsgeschwindigkeit, Druck und Gasfluß (Strömungsrate) können nun frei zur Verbesserung des Wachstumsprozesse optimiert werden ohne Einbußen bei den Eigenschaften der Strömung hinnehmen zu müssen.

Die Vorrichtung gemäß der Erfindung wird vorzugsweise zum Aufwachsen von Schichten auf Substraten verwendet, insbesondere zum Aufwachsen von einkristallinen Siliciumcarbidschichten oder einkristallinen Galliumnitridschichten durch einen CVD-Prozeß.

Als Prozeßgase für den Prozeßgasstrom 5 werden dazu zum Aufwachsen von SiC-Schichten Arbeitsgase zum Zuführen von Silicium (Si) und Kohlenstoff (C) und vorzugsweise wenigstens ein Trägergas, das im allgemeinen Wasserstoff ist, und gegebenenfalls auch ein Dotiergas zum Dotieren des aufwachsenden Siliciumcarbids verwendet. Beim Auftreffen des Gasgemisches des Prozeßgasstromes 5 auf das beheizte Substrat scheidet sich durch chemische Reaktion aus den Arbeitsgasen (Quellgasen) unter Mitwirkung des Wasserstoffträgergases Siliciumcarbid ab. Als Substrate werden insbesondere Substrate aus einkristallinem Siliciumcarbid verwendet (Epitaxie). Die Temperaturen am Substrat werden über die Energie der Induktionsspule 4 eingestellt. Zum Aufwachsen von Siliciumcarbid werden im allgemeinen Wachstumstemperaturen am Substrat zwischen etwa 900°C und etwa 2500°C eingestellt.

Die Vorrichtung kann überdies auch zum Herstellen von einkristallinen Galliumnitrid(GaN)-Schichten durch CVD verwendet werden. Die Substrate zum Aufwachsen der GaN-Schichten können insbesondere aus Al₂O₃ bestehen oder auch aus SiC. Die Wachstumstemperaturen am Substrat werden beim GaN-CVD-Prozeß vorzugsweise zwischen etwa 950° C und etwa 1100° C eingestellt. Als Arbeitsgase eignen sich insbesondere Ammoniak und Galliumkohlenstoffverbindungen wie beispielsweise Trimethyloder Triethylgallium.

Vorzugsweise sind die Trägerschale 9 und der Trägerstab 11 aus einem gegenüber dem Prozeßgasstrom 5 inerten Material oder zumindest mit einem inerten Material beschichtet, beispielsweise mit Tantalcarbid oder mit Siliciumcarbid zum Herstellen von SiC-Schichten. Außerdem kann der Trägerstab 11 auch mit einem Inertgas gespült werden, um einen Kontakt mit dem Prozeßgasstrom 5 zu unterbinden. Vorzugsweise ist der Trägerstab 11 auch über die gasdichte Öffnung 19 entlang seiner Längsachse verschiebbar werden, um den Ein- und Ausbau der Substrate in dem Reaktor 16 zu erleichtern.

## Patentansprüche

1. Vorrichtung zum Behandeln wenigstens eines Substrats (2,2A bis 2E) mit
a) wenigstens einem mit dem wenigstens einen Substrat (2,2A bis E) thermisch gekoppelten Suszeptor (3) und
b) einer Induktionsheizeinrichtung (4) zum induktiven Erhitzen des wenigstens einen Suszeptors (3),
wobei
c) die Induktionsheizeinrichtung (4) und der wenigstens eine Suszeptor (3) so zueinander angeordnet sind, daß eine durch die Induktionsheizeinrichtung (4) auf den wenigstens einen Suszeptor (3) einwirkende elektromagnetische Kraft (**F**_{**EM**}) wenigstens annähernd parallel zur Gravitationskraft (**G**) gerichtet ist.

2. Vorrichtung nach Anspruch 1, bei der die Induktionsheizeinrichtung wenigstens eine Induktionsspule (4) umfaßt.

3. Vorrichtung nach Anspruch 2, bei der das wenigstens eine Substrat (2) zwischen dem wenigstens einen Suszeptor (3) und der Induktionsspule (4) angeordnet ist.

4. Vorrichtung nach Anspruch 2, bei der der wenigstens eine Suszeptor (3) zwischen der Induktionsspule (4) und dem wenigstens einen Substrat (2) angeordnet ist.

5. Vorrichtung nach einem der vorhergehenden Ansprüche mit wenigstens einer Trägereinrichtung (7,8,9) zum Tragen des wenigstens einen Substrats (2) und des wenigstens einen Suszeptors (3).

6. Vorrichtung nach Anspruch 5, bei der die Trägereinrichtung eine Trägerschale (9) mit jeweils einer Öffnung und einer die Öffnung umgebenden Auflagefläche (92A bis 92D) für jedes Substrat (2A bis 2D) umfaßt, wobei der Suszeptor (3) in die Trägerschale einlegbar ist.

7. Vorrichtung nach Anspruch 5 mit einem Trägerstab (11), auf dem die Trägerschale (9) abgestützt ist.

8. Vorrichtung nach Anspruch 4, bei der der Suszeptor (3) an seiner von der Induktionsspule (4) abgewandten Seite für jedes Substrat (2A bis 2F) wenigstens eine Einstecklasche (12A bis 12E) zum Befestigen des wenigstens einen Substrats (2A bis 2E) aufweist.

9. Vorrichtung nach einem der vorangegangenen Ansprüche mit Rotationsmitteln zum Rotieren jedes Substrats um eine vorgegebene Drehachse.

10. Vorrichtung nach einem der vorhergehenden Ansprüche zum Abscheiden einer Schicht (6) auf einer Oberfläche (20) des wenigstens einen Substrats (2A,2C) mit Mitteln (16,18) zum Richten eines Prozeßgasstromes auf die Oberfläche des wenigstens einen Substrats (2A,2C) zum chemischen Abscheiden der Schicht (6) aus dem Prozeßgasstrom.

11. Vorrichtung nach Anspruch 10, bei der die Mittel zum Richten des Prozeßgasstromes auf die Oberfläche des Substrats so ausgebildet sind, daß die Strömungsrichtung (R) des Prozeßgasstromes (5) wenigstens im Bereich der Oberfläche des Substrats wenigstens annähernd antiparallel zur Gravitationskraft (G) gerichtet ist.

12. Verwendung einer Vorrichtung nach Anspruch 10 oder Anspruch 11 zum Abscheiden einer Schicht aus einkristallinem Siliciumcarbid.

13. Verwendung einer Vorrichtung nach Anspruch 10 oder Anspruch 11 zum Abscheiden einer Schicht aus einkristallinem Galliumnitrid.

## Claims

1. Apparatus for treatment of at least one substrate (2, 2A to 2E) with
a) at least one susceptor (3) thermally coupled with the at least one substrate (2, 2A to E) and
b) an induction heating device (4) for the inductive heating of the at least one susceptor (3),
with
**c)** the induction heating device (4) and the at least one susceptor (3) being arranged in relation to each other in such a way that an electromagnetic force (**F**_{**EM**}) acting on the at least one susceptor (3) due to the induction heating device (4) is directed at least approximately parallel to the gravitational force **(G).**

2. Apparatus according to Claim 1, in which the induction heating device comprises at least one induction coil (4).

3. Apparatus according to Claim 2, in which the at least one substrate (2) is arranged between the at least one susceptor (3) and the induction coil (4).

4. Apparatus according to Claim 2, in which the at least one susceptor (3) is arranged between the induction coil (4) and the at least one substrate (2).

5. Apparatus according to one of the preceding claims, with at least one supporting device (7, 8, 9) for supporting the at least one substrate (2) and the at least one susceptor (3).

6. Apparatus according to Claim 5, in which the supporting device comprises a supporting dish (9), with in each case an opening and a bearing surface (92A to 92D), surrounding the opening, for each substrate (2A to 2D), it being possible for the susceptor (3) to be placed into the supporting dish.

7. Apparatus according to Claim 5, with a supporting rod (11), on which the supporting dish (9) is supported.

8. Apparatus according to Claim 4, in which the susceptor (3) has on its side facing away from the induction coil (4) for each substrate (2A to 2F [sic]) at least one insertion tab (12A to 12E) for fastening the at least one substrate (2A to 2E).

9. Apparatus according to one of the preceding claims, with means of rotation for rotating each substrate about a predetermined axis of rotation.

10. Apparatus according to one of the preceding claims for depositing a layer (6) on a surface (20) of the at least one substrate (2A, 2C), with means (16, 18) for directing a process gas stream onto the surface of the at least one substrate (2A, 2C) for chemically depositing the layer (6) from the process gas stream.

11. Apparatus according to Claim 10, in which the means for directing the process gas stream onto the surface of the substrate are designed in such a way that the direction of flow (R) of the process gas stream (5) is directed at least approximately antiparallel to gravitational force **(G),** at least in the region of the surface of the substrate.

12. Use of an apparatus according to Claim 10 or Claim 11 for depositing a layer of monocrystalline silicon carbide.

13. Use of an apparatus according to Claim 10 or Claim 11 for depositing a layer of monocrystalline gallium nitride.

## Revendications

1. Dispositif pour traiter au moins un substrat (2, 2A à 2E) comportant
a) au moins un suscepteur (3) couplé du point de vue thermique avec le au moins un substrat (2, 2A à E) et
b) un dispositif (4) de chauffage par induction pour chauffer de manière inductive le au moins un suscepteur (3),
c) le dispositif (4) de chauffage par induction et le au moins un suscepteur (3) étant montés l'un par rapport à l'autre de manière qu'une force (F_{EM}) électromagnétique agissant par le dispositif (4) de chauffage par induction sur le au moins un suscepteur (3) soit dirigée au moins à peu près parallèlement à la force de gravitation.

2. Dispositif suivant la revendication 1, dans lequel le dispositif de chauffage par induction comprend au moins une bobine (4) d'induction.

3. Dispositif suivant la revendication 2, dans lequel le au moins un substrat (2) est monté entre le au moins un suscepteur (3) et la bobine (4) d'induction.

4. Dispositif suivant la revendication 2, dans lequel le au moins un suscepteur (3) est monté entre la bobine (4) d'induction et le au moins un substrat (2).

5. Dispositif suivant l'une des revendications précédentes, comportant au moins un dispositif (7, 8, 9) de support pour porter le au moins un substrat (2) et le au moins un suscepteur (3).

6. Dispositif suivant la revendication 5, dans lequel le dispositif de support comprend une coquille (9) de support ayant respectivement une ouverture et une surface (92A à 92D) de support entourant l'ouverture pour chaque substrat (2A à 2D), le suscepteur (3) pouvant être introduit dans la coquille de support.

7. Dispositif suivant la revendication 5, comportant une barre (11) de support sur laquelle la coquille (9) de support prend appui.

8. Dispositif suivant la revendication 4, dans lequel le suscepteur (3) comporte de son côté éloigné de la bobine (4) d'induction, pour chaque substrat (2A à 2F), au moins une patte (12A à 12E) d'enfichage pour la fixation du au moins un substrat (2A à 2E).

9. Dispositif suivant l'une des revendications précédentes, comportant des moyens de rotation pour faire tourner chaque substrat par rapport à un axe de rotation prescrit.

10. Dispositif suivant l'une des revendications précédentes, pour déposer une couche (6) sur une surface (20) du au moins un substrat (2A, 2C) comportant des moyens (16, 18) pour diriger un courant de gaz opératoires vers la surface du au moins un substrat (2A, 2C) pour dépôt chimique de la couche (6) à partir du courant de gaz opératoires.

11. Dispositif suivant la revendication 10, dans lequel les moyens pour diriger le courant de gaz opératoires vers la surface du substrat sont réalisés de manière que la direction (R) d'écoulement du courant (5) de gaz opératoires soit dirigée au moins dans la région de la surface du substrat au moins à peu près de manière antiparallèle à la force (G) de gravitation.

12. Utilisation d'un dispositif suivant la revendication 10 ou la revendication 11 pour déposer une couche de carbure de silicium monocristallin.

13. Utilisation d'un dispositif suivant la revendication 10 ou la revendication 11 pour déposer une couche de nitrure de gallium monocristallin.
